(19) Europäisches Patentamt
European Patent Office
Office européen des brevets

(11) EP 0 711 417 B1

(12) **EUROPEAN PATENT SPECIFICATION**

(45) Date of publication and mention
of the grant of the patent:
**07.01.1998 Bulletin 1998/02**

(21) Application number: **94924496.6**

(22) Date of filing: **26.07.1994**

(51) Int Cl.6: **G01R 29/08**, H04B 1/38,
H01Q 1/24

(86) International application number:
**PCT/US94/08435**

(87) International publication number:
**WO 95/03549 (02.02.1995 Gazette 1995/06)**

(54) **METHOD AND APPARATUS FOR CONTROLLING THE EXPOSURE TO RF TRANSMISSIONS**

VERFAHREN UND VORRICHTUNG ZUR KONTROLLE DER BELASTUNG MIT RADIOWELLE

METHODE ET APPAREIL DE REGULATION DE L'EXPOSITION AUX TRANSMISSIONS
RADIOELECTRIQUES

(84) Designated Contracting States:
**AT BE CH DE DK ES FR GB GR IE IT LI LU MC NL
PT SE**
Designated Extension States:
**SI**

(30) Priority: **26.07.1993 US 96495**

(43) Date of publication of application:
**15.05.1996 Bulletin 1996/20**

(73) Proprietor: **QUALCOMM INCORPORATED
San Diego, California 92121 (US)**

(72) Inventors:
* **CARTER, Steve
San Diego, CA 92126 (US)**
* **GILHOUSEN, Klein, S.
Bozeman, MT 59715 (US)**

(74) Representative: **Walsh, Michael Joseph et al
TOMKINS & CO.
5, Dartmouth Road
Dublin 6 (IE)**

(56) References cited:
**US-A- 4 634 969        US-A- 5 086 508
US-A- 5 168 265**

* **IEEE TRANSACTIONS ON ANTENNAS AND
PROPAGATION, vol.41, no.6, June 1993, NEW
YORK US pages 739 - 746, XP000387365
TOFTGARD ET AL 'effects on portable antennas
of the presence of a person'**
* **NEW SCIENTIST, vol.134, no.1824, 6 June 1992,
LONDON GB page 19 PATEL 'the yuppie
gamma-ray detector'**

## Description

## BACKGROUND OF THE INVENTION

### I. Field of the Invention

The present invention relates to communication systems where the antenna radiation is in close proximity to the user. More particularly, the present invention relates to a novel and improved method and apparatus for monitoring RF exposure levels associated with the use of handheld transmitters and providing response measures when the exposure to the RF transmissions exceeds a predetermined threshold value.

### II. Description of the Related Art

It is frequently desirable to have self-contained handheld personal communications units for their convenience and mobility. These features have given rise to an enormous demand for the handheld units. In response to the demand, industry has desired to place in effect a series of precautionary measures to monitor and control the user's RF exposure.

The paper "Effects on Portable Antennas of the Presence of a Person" by Jorn Toftgard, Sten N. Hornsleth, and Jorgen Bach Andersen, 8082 IEEE Transactions on Antennas and Propagation 41(1993) June, No. 6, New York, US, deals with the influence the presence of a person has on the performance of antennas for handheld portable telephones. It shows how input impedance, far-field radiation pattern, radiation efficiency, and the magnitude of the near field are affected by the presence of the human body. The investigations were carried out by applying the finite difference time domain technique to a model of the telephone with a $\lambda/4$ monopole antenna and a simple handheld model of the operator. Results from this configuration are compared with results for the telephone box and antenna alone. Measurements were performed to verify the results obtained by simulations. The results show that a shadow effect in the far-field pattern occurs in the direction of the person and that the radiation pattern, including polarization, changes considerably from the telephone with the antenna alone. The impedance results show a change in the resonance frequency when the telephone is placed next to a person. Results for radiation efficiency show that close to half of the energy is absorbed by hand and head. The authors propose that on average a system loss of 3-4 dB should be included in a link budget, and there is considerable fading, even in a radio-anechoic chamber, when persons move around in a natural manner.

US-A-5,086,508 to Furuno describes a radio transceiver including a control section for setting a transmitting output level higher or lower than a prescribed output level within a tolerance range, in response to a signal from a level conversion circuit. The level conversion circuit may designate a lower transmitting output level to reduce power consumption, and may designate a higher transmitting output level in the presence of high noise levels.

## SUMMARY OF THE INVENTION

The invention in its widest aspect is set forth in system Claim 1 and method Claim 9 written in two-part format relative to US-A-5,086,508 as nearest prior art, and in circuit Claims 17 and 18.

The present invention is a novel and improved method and apparatus for controlling user RF exposure levels. In accordance with the present invention the total amount of energy transmitted is measured until a predetermined exposure level within a fixed time period is reached at which time an automated sequence of preventative measures commences.

The transmission circuitry of a handheld telephone is comprised essentially of an antenna and a power amplifier coupled to the antenna. In general, the power amplifier is responsive to a power level request signal that determines the transmission power from the antenna.

In the present invention, the transmission energy is monitored throughout the telephone operation, either by monitoring the power level request signal or by monitoring the output of the power amplifier. The amount of transmitted energy in a fixed period of time is accumulated by an integrator, which may take the form of a leaky integrator or a sliding window accumulator depending on whether the monitored signal is an analog or digital format. This accumulated value of transmitted energy is compared to a predetermined threshold. When the accumulated value exceeds the predetermined threshold, a signal is sent to a hazard control processor and precautionary steps are actuated.

In a more elegant implementation of the present invention, the accumulated transmission energy is compared against an intermediate level or a series of intermediate levels. After the accumulated energy exceeds each of said intermediate thresholds, new precautionary steps are taken until the transmission power is reduced or until a final threshold is surpassed, at which time the transmit power is reduced or eliminated.

## BRIEF DESCRIPTION OF THE DRAWINGS

The features, objects, and advantages of the present invention will become more apparent from the detailed description set forth below when taken in conjunction with the drawings, in which like reference characters identify correspondingly throughout, and wherein:

Figure 1 is an illustration of the RF exposure associated with the use of portable communications devices;
Figure 2 is a flowchart of the steps of the RF exposure monitor and control system; and
Figure 3 is an exemplary embodiment of the RF exposure monitor and control apparatus.

## DETAILED DESCRIPTION OF THE PREFERRED EMBODIMENTS

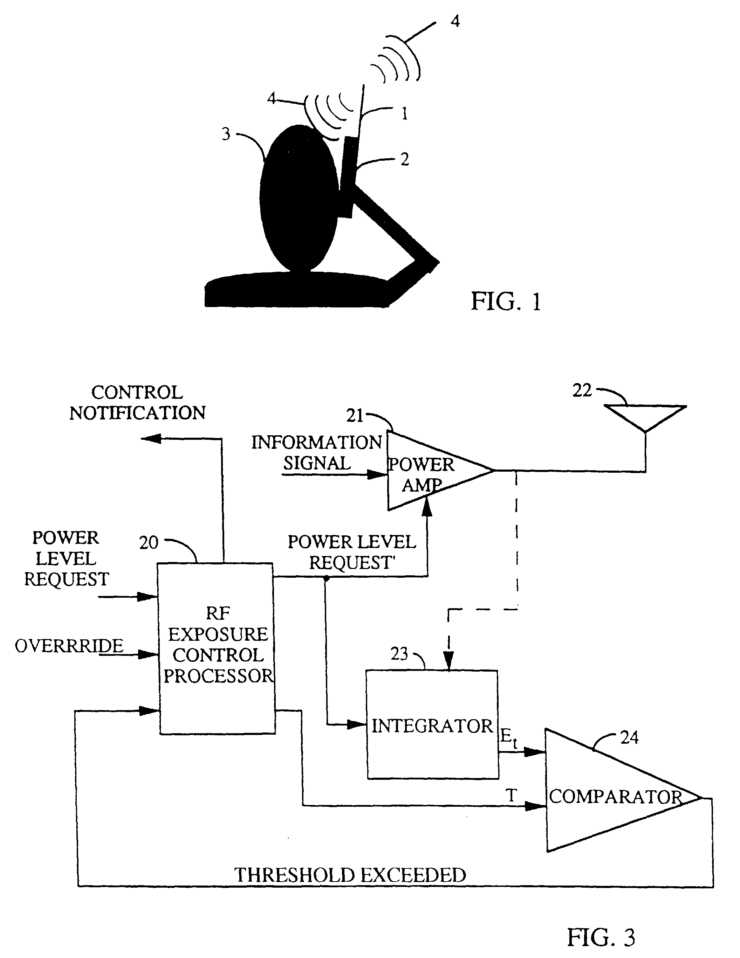

Referring now to the drawings, Figure 1 illustrates the RF exposure associated with the use of portable personal communication devices, such as cellular telephones or similar devices. The proximity of the antenna 1 of the portable phone 2 to the user's body 3 is of interest. The electromagnetic energy 4 emanating from antenna 1 of phone 2 is the source of interest. The control and monitoring of RF exposure is the objective of the present invention.

In portable communication devices, transmitter power is increased and decreased to maintain a quality communication link. In a fading environment or in the situation in which the transmission path is obstructed, the portable communication device increases transmission power to maintain link quality. The level of transmission energy and the changes thereto should be monitored. Therefore proper control processes and circuitry are needed to limit the RF exposure level.

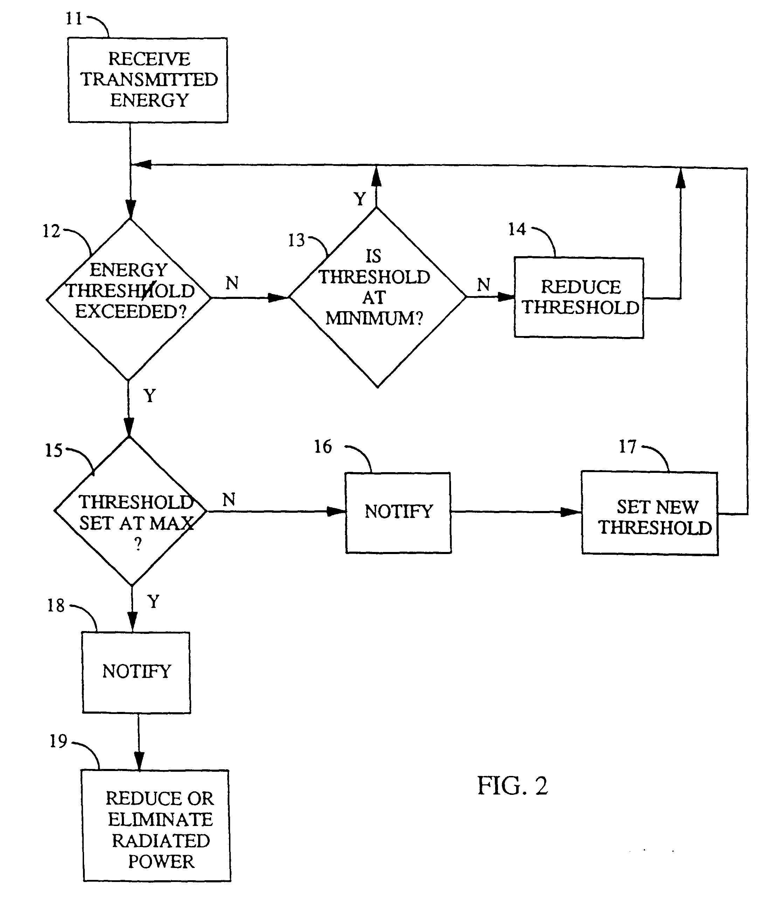

Figure 2 illustrates a flowchart of the steps involved in controlling the exposure levels of RF transmissions of the present invention. The accumulated energy is obtained, block 11, and compared against a current energy threshold, block 12. If in block 12, the accumulated energy value is determined to be less than the current threshold, the system checks if the threshold value is set to its minimum value, block 13. If in block 13, the threshold value is determined not to be at its minimum value, the threshold value is decreased by a predetermined decrement, block 14.

If in block 12, the current energy threshold is determined to be exceeded, a check is made to determine if the threshold is an intermediate threshold or the maximum threshold, block 15. If in block 15, the threshold is determined to be an intermediate threshold, the following precautionary steps are actuated. The user is notified, block 16, and the energy threshold value is increased to a greater value, block 17.

The above described procedure continues until such time that the threshold value is determined to no longer be an intermediate value, but rather a maximum value in block 15 that will not be increased. At this time the user is notified, block 18, and the radiated power is reduced or eliminated block 19.

Figure 3 illustrates an exemplary embodiment of the present invention in a communications device. Power level requests which control transmission power are processed through an RF Exposure Control Processor 20 before being passed on to the power amplifier 21 as a Power Level Request' signal. The power amplifier 21 is responsive to the Power Level Request' signal for amplifying the input information signal to provide a transmission signal at a predetermined transmission power level to antenna 22. The information signal may be in either analog or digital format. The input information signal might be in analog or digital form and modulated for transmission using TDMA, CDMA, FM or any other modulation scheme well known in the art.

In satellite based portable telephone systems, the typical transmission frequencies are in the range of approximately 1610 - 1626.5 MHz. These telephones are designed to operate in the power range between 100mW and 1W. It should be noted the present invention is equally applicable to any transmission frequencv or power range of either satellite or terrestrial based communication system.

In a preferred embodiment an integrator 23 taps off of the Power Level Request Signal from RF Exposure Control Processor 20. In an alternative embodiment, the integrator could tap off the output of the power amplifier for its measurement of transmitted energy (as illustrated by the dashed line in Figure 3). The integrator can be in the form of a leaky integrator if the power request signal is analog in nature or a sliding window accumulator if the power request signal is digital in nature. The transmitted energy is ideally calculated using the formulas:

$$E_t = \int_{t}^{t+\Delta t} \text{Power}(t)\, dt \qquad (1)$$

where $E_t$ is the transmitted energy and Power(t) is the transmission power as a function of time, or

$$E_t = \sum_{i=n}^{n+m} \text{Power}(i) \bullet \Delta t \qquad\qquad (2)$$

where $E_t$ is the transmitted energy and Power(i) is the transmission power as a function of sample number.

The computation of equation 1 can be accomplished using an analog integrator, as is well known in the art, and the computation of equation 2 can be accomplished using digital accumulating circuitry which is also well known in the art. There are simplified implementations that approximate the functions of Equations 1 and 2. For example, 2 simple RC network can approximate the analog integral of Equation 1. The integration or summation period used in the exemplary embodiment may be 6 minutes, or any other selected time period. The period of integration is a programmable quantity and can be varied to conform to local laws or differing needs.

In addition, the integration need not be a linear process. Instead, the rate of accumulation or integration may be weighted based on the characteristics of the RF transmission at any given time. At the present, it is commonly believed that the significance of the radiation exposure is simply proportional to the total amount of accumulated exposure. However, it is envisioned in the present invention that in an alternative model wherein the characteristics of the RF transmissions are of interest to the user, the integration can be weighted in accordance with these characteristics Characteristics that could be taken into effect and be weighted accordingly may include the frequency of the electromagnetic radiation, the intensity of the radiation, or any other measurable characteristic of the radiation.

The transmitted energy ($E_t$) is compared against the current threshold value (T) provided by RF Exposure Control Processor 20, by means of a comparator 24. In the exemplary embodiment, the current threshold value is stored within a ROM or RAM memory storage device associated with the RF Exposure Control Processor 20. The threshold values are also programmable and can be varied to conform to local laws or differing needs. A suggested maximum exposure threshold might be 180 Joules of transmitted energy in a 6 minute period. So in the exemplary embodiment an initial threshold might be set at 90 Joules of transmitted energy in a 6 minute period. If the initial threshold, as supplied by RF Exposure Control Processor 20, is exceeded, then comparator 24 sends the Threshold Exceeded signal back to RF Exposure Control Processor 20.

At this point the RF Exposure Control Processor 20 sends out a Control Notification signal that makes the user aware of the condition. For example in response to the Control Notification Signal, the communications device may provide either an audio or visual warning or both. The visual alert for example may take the form of a script warning on a digital display on the communications device or an illumination of an indicator lamp. The user, in response to the warning, can take measures to reduce the needed transmission energy by reducing the inpath interference. The RF Exposure Control Processor 20 then increases the threshold value and allows the user to continue operation.

The process of increasing the threshold values continues until at some point the threshold value has reached its maximum value, at which time the RF Exposure Control Processor 20 modifies the Power Level Request signal to reduce or eliminate the transmission radiation. If, on the other hand, the accumulated value is less than the current threshold value for a predetermined period of time, the threshold is reduced. The process of reducing the threshold value continues until the threshold value is reduced to its minimum value.

An optional feature which may be added to the present invention is a system override subsystem. As illustrated in Figure 3, a override signal can be provided to the RF Exposure Control Processor 20 by the user in cases where it is necessary to maintain the high transmission power. The override subsystem of RF Exposure Control Processor 20 would in response to the override signal inactivate the hazard control processor and allow the power request signal to pass through RF Exposure Control Processor 20 unaltered. A subsystem of this type could, for example, be invoked under emergency circumstances that dictate that a transmission must get out. The design of such override systems are well known in the art.

Although in the diagrams and in the text the system has been illustrated as an autonomous system controlled by its own processor, the present invention can reside partially or entirely in the existing processing elements of the portable communications device.

The previous description of the preferred embodiments is provided to enable any person skilled in the art to make or use the present invention. The various modifications to these embodiments will be readily apparent to those skilled in the art, and the generic principles defined herein may be applied to other embodiments without the use of the inventive faculty.

**Claims**

1. A system comprising a communications device (2) having a transmitter and an antenna (1, 22), and an apparatus for limiting the transmission power of said transmitter, said apparatus comprising:

comparison means (24) for comparing a transmission energy value ($E_t$) against a threshold value (T) to generate a comparison result signal;

response means (20) for receiving said comparison result signal and when said comparison result signal indicates that said transmission energy value ($E_t$) exceeds said threshold (T), limiting the transmission power (Power (t) or Power (i)) of said transmitter;

characterized in that

said apparatus is for limiting the exposure level to a user (3) of RF transmissions (4) from said communications device (2);

and in that said apparatus further comprises means (23) for determining the amount of energy transmitted by said antenna (1, 22) in a predetermined length of time ($\Delta t$) to generate an accumulated energy value ($E_t$) which constitutes said transmission energy value.

2. The system of Claim 1 wherein said means (23) for determining comprises a sliding window accumulator.

3. The system of Claim 1 wherein said means (23) for determining comprises a leaky integrator.

4. The system of Claim 1, 2 or 3 wherein said response means (20) is additionally for notifying the user of a condition of high transmission radiation exposure when said comparison result signal indicates that said accumulated energy value ($E_t$) exceeds said threshold (T).

5. The system of any preceding claim wherein said response means (20) is further for, when said comparison result signal is indicative of said accumulated energy value ($E_t$) exceeding said threshold value (T), comparing said threshold value (T) with a predetermined maximum threshold value, and if said threshold value (T) is less than said maximum threshold value, increasing said threshold value.

6. The system of Claim 5 wherein said response means (20) is further for, when said comparison result signal is indicative of said accumulated energy value ($E_t$) being less than said threshold value (T), reducing said threshold value (T).

7. The system of Claim 5 wherein said response means (20) is further for, when said comparison result signal is indicative of said accumulated energy value ($E_t$) being less than said threshold value (T), comparing said threshold value (T) with a predetermined minimum threshold value, and reducing said threshold value (T) only when said threshold value (T) is greater than said minimum threshold value.

8. The system of Claim 6 wherein said response means (20) is further for reducing said threshold value (T) only when said threshold value (T) is greater than a minimum threshold value.

9. A method for use in connection with a communications device (2) having a transmitter and an antenna (1, 22) for limiting the transmission power of said transmitter, comprising:

comparing a transmission energy value ($E_t$) against a threshold value (T);

generating a comparison result signal; and

limiting the transmission power (Power (t) or Power (i)) of said transmitter, if said comparison result signal is indicative of said transmission energy ($E_t$) value exceeding said threshold value (T).

characterized in that

said method is for limiting the exposure level to a user (3) of RF transmissions (4) from said communications device (2); and

said method includes the further step of determining the amount of energy transmitted by said antenna (1, 22) in a predetermined length of time ($\Delta t$) to generate an accumulated energy value ($E_t$) which constitutes a trans-

mission energy value.

10. The method of Claim 9 wherein said step of determining the amount of energy transmitted by said antenna (1, 22) comprises summing transmission power (Power (i)) for a predetermined number of transmitted symbols (m).

11. The method of Claim 9 wherein said step of determining the amount of energy transmitted by said antenna (1, 22) comprises integrating transmission power (Power (t)) over a predetermined time-interval ($\Delta t$).

12. The method of Claim 9, 10 or 11 further comprising the step of notifying the user when said comparison result is indicative of said accumulated energy value ($E_t$) exceeding said threshold value (T).

13. The method of Claim 9 further comprising the step of increasing said threshold responsive to said comparison result signal, if said comparison result is indicative of said accumulated energy value ($E_t$) exceeding said threshold value (T).

14. The method of Claim 13 further comprising the step of decreasing said threshold responsive to said comparison result signal, if said comparison result is indicative of said accumulated energy value ($E_t$) being less than said threshold value (T).

15. The method of Claim 13 further comprising the steps of comparing said threshold value (T) with a predetermined maximum threshold value, and increasing said threshold value (T) only when said threshold value (T) is less than said predetermined maximum threshold value.

16. The method of Claim 14 further comprising the steps of comparing said threshold value (T) with a predetermined minimum threshold value, and reducing said threshold value (T) only when said threshold value (T) is greater than said predetermined minimum threshold value.

17. A handheld communication device (2) having a transmitter and an antenna (1, 22), including a circuit for controlling the exposure levels to a user (3) of said communication device (2) of RF transmissions (4) emanating from said antenna (1, 22) comprising:

   an RF exposure control processor (20) with two inputs, with a first input for receiving a power request signal, and having two outputs with a first output for providing an exposure threshold value and a second output for providing a modified power request signal;

   an amplifier (21) having two inputs with a first input for receiving an information signal and a second input for receiving said modified power request signal and having an output for providing an amplified information signal to the antenna (1, 22);

   a leaky integrator (23) having an input coupled to said modified power request signal and having an output for determining the amount of energy transmitted by said antenna (1, 22) in a predetermined length of time; and

   a comparator (24) having two inputs and an output, with a first input coupled to the output of said leaky integrator (23), and a second input coupled to said first output of said exposure control processor (20) and wherein said output is coupled to a second input of said exposure control processor (20).

18. A handheld communications device (2) having a transmitter and an antenna (1, 22), including a circuit for controlling the exposure levels to a user (3) of said communications device (2) of RF transmissions (4) emanating from said antenna (1, 22) comprising:

   an RF exposure control processor (20) with two inputs, with a first input for receiving a power request signal, and having two outputs with a first output for providing an exposure threshold value and a second output for providing a modified power request signal;

   an amplifier (21) having two inputs with a first input for receiving an information signal and a second input for receiving said modified power request signal and having an output for providing an amplified information signal to the antenna (1, 22);

a sliding window accumulator (23) having an input coupled to said modified power request signal and having an output for determining the amount of energy transmitted by said antenna (1, 22) in a predetermined length of time; and

a comparator (24) having two inputs and an output, with a first input coupled to the output of said sliding window accumulator (23), and a second input coupled to said first output of said exposure control processor (20) and wherein said output is coupled to a second input of said exposure control processor (20).

19. The communication device (2) of Claim 17 or 18 wherein said exposure control processor (20) further comprises a third output for providing a control notification signal.

## Patentansprüche

1. Ein System, welches eine Nachrichtenvorrichtung (2) mit einem Sender und einer Antenne (1, 22) aufweist, und mit einer Vorrichtung zur Begrenzung der Übertragungsleistung des Senders, wobei die Vorrichtung folgendes aufweist:

Vergleichsmittel (24) zum Vergleich eines Sendeenergiewertes ($E_t$) mit einem Schwellenwert (T) zur Erzeugung eines Vergleichsergebnissignals;
Ansprechmittel (20) zum Empfang des Vergleichsergebnissignals und zur Begrenzung der Sendeleistung (Leistung (t) oder Leistung (i)) des Senders, dann, wenn das erwähnte Vergleichsergebnissignal anzeigt, daß der Sendeenergiewert ($E_t$) den Schwellenwert (T) übersteigt,

dadurch **gekennzeichnet**, daß

die Vorrichtung zur Begrenzung des Aussetzungspegels dient, dem ein Benutzer (3) gegenüber HF-Übertragungen (4) von der Nachrichtenvorrichtung (2) ausgesetzt ist; und
daß die Vorrichtung ferner Mittel (23) aufweist, um die durch die Antenne (1, 22) in einer vorbestimmten Zeitspanne oder Zeitlänge ($\Delta t$) übertragene Energiemenge zu bestimmen, und zwar zur Erzeugung eines akkumulierten Energiewertes ($E_t$), der den erwähnten Sendeenergiewert bildet.

2. System nach Anspruch 1, wobei die Bestimmungsmittel (23) einen Akkumulator mit gleitendem Fenster aufweisen.

3. System nach Anspruch 1, wobei die Bestimmungsmittel (23) einen mit Verlusten behafteten (leaky)- Integrator aufweisen.

4. System nach Anspruch 1, 2 oder 3, wobei die Ansprechmittel (20) zusätzlich dazu dienen, die Benutzer auf einen Zustand hoher Sendestrahlungsaussetzung hinzuweisen, wenn das Vergleichsergebnissignal anzeigt, daß der akkumulierte Energiewert ($E_t$) die Schwelle (den Schwellenwert) (T) übersteigt.

5. System, nach einem der vorhergehenden Ansprüche, wobei die Ansprechmittel (20) ferner dann, wenn das Vergleichsergebnissignal anzeigt, daß der akkumulierte Energiewert ($E_t$) den Schwellenwert (T) übersteigt, den Schwellenwert mit einem vorbestimmten maximalen Schwellenwert vergleichen und wenn der Schwellenwert (T) kleiner als der maximale Schwellenwert ist, den Schwellenwert erhöhen.

6. System nach Anspruch 5, wobei die Ansprechmittel (20) ferner den erwähnten Schwellenwert (T) dann reduzieren, wenn das erwähnte Vergleichsergebnissignal eine Anzeige dafür bildet, daß der akkumulierte Energiewert ($E_t$) kleiner ist als der erwähnte Schwellenwert (T).

7. System nach Anspruch 5, wobei die Ansprechmittel (20) ferner dazu dienen, dann, wenn das erwähnte Vergleichsergebnissignal eine Anzeige dafür bildet, daß der akkumulierte Energiewert ($E_t$) kleiner ist als der Schwellenwert (T), den erwähnten Schwellenwert (T) mit einem vorbestimmten minimalen Schwellenwert zu vergleichen und den erwähnten Schwellenwert (T)nur dann zu reduzieren, wenn der Schwellenwert (T) größer ist als der erwähnte minimale Schwellenwert.

8. System nach Anspruch 6, wobei die Ansprechmittel (20) ferner zum Reduzieren des erwähnten Schwellenwerts (T) dienen, und zwar nur dann, wenn der Schwellenwert (T) größer ist als ein minimaler Schwellenwert.

9. Verfahren zur Verwendung in Verbindung mit einer Nachrichtenvorrichtung (2) mit einem Sender und einer Antenne (1, 22) zur Begrenzung der Sendeleistung des Senders, wobei folgendes vorgesehen ist:

Vergleichen eines Sendeenergiewertes ($E_t$) mit einem Schwellenwert (T);
Erzeugen eines Vergleichsergebnissignals; und
Begrenzen der Sendeleistung (Leistung (t) oder Leistung (i)) des Senders, dann wenn das Vergleichsergebnissignal eine Anzeige dafür bildet, daß der erwähnte Sendeenergiewert ($E_t$) den erwähnten Schwellenwert (T) übersteigt,

dadurch **gekennzeichnet**, daß

das erwähnte Verfahren zur Begrenzung des Aussetzungspegels eines Benutzers (3) gegenüber HF-Übertragungen (4) von der erwähnten Nachrichtenvorrichtung (2) dient; und
daß das Verfahren ferner den Schritt der Bestimmung der durch die erwähnte Antenne (1, 22) in einer vorbestimmten Zeitspanne oder Zeitlänge ($\Delta t$) übertragenen Energiemenge (Energiegröße) dient, um einen akkumulierten Energiewert ($E_t$) zu erzeugen, der einen Sendeenergiewert bildet.

10. Verfahren nach Anspruch 9, wobei der Schritt der Bestimmung, der durch die Antenne (1, 22) übertragenen Energiemenge das Summieren der Sendeleistung (Leistung (i)) für eine vorbestimmte Anzahl von übertragenen Symbolen (m) aufweist.

11. Verfahren nach Anspruch 9, wobei der Schritt des Bestimmens, der durch die Antenne (1, 22) übertragenen Energiemenge das Integrieren der Sendeleistung (Leistung (t)) über ein vorbestimmtes Zeitintervall ($\Delta t$) aufweist.

12. Verfahren nach Anspruch 9, 10 oder 11, wobei ferner der Schritt des Benachrichtigens oder Notifizierens des Benutzers vorgesehen ist, wenn das Vergleichsergebnis eine Anzeige dafür bildet, daß der akkumulierte Energiewert ($E_t$) den erwähnten Schwellenwert (T) übersteigt.

13. Verfahren nach Anspruch 9, wobei ferner der Schritt des Erhöhens des Schwellenwerts ansprechend auf das erwähnte Vergleichsergebnissignal vorgesehen ist, und zwar dann, wenn das Vergleichsergebnis anzeigt, daß der akkumulierte Energiewert ($E_t$) den Schwellenwert (T) übersteigt.

14. Verfahren nach Anspruch 13, wobei ferner der Schritt des Verringerns der Schwelle (Schwellenwert) ansprechend auf das Vergleichsergebnissignal vorgesehen ist, und zwar dann, wenn das Vergleichsergebnis eine Anzeige dafür bildet, daß der akkumulierte Energiewert ($E_t$) kleiner ist als der erwähnte Schwellenwert (T).

15. Verfahren nach Anspruch 13, wobei ferner die folgenden Schritte vorgesehen sind: Vergleichen des Schwellenwerts (T) mit einem vorbestimmten maximalen Schwellenwert, und Vergrößern des erwähnten Schwellenwerts (T) nur dann, wenn der Schwellenwert (T) kleiner ist als der vorbestimmte maximale Schwellenwert.

16. Verfahren nach Anspruch 14, wobei ferner die folgenden Schritte vorgesehen sind: Vergleichen des erwähnten Schwellenwerts (T) mit einem vorbestimmten minimalen Schwellenwert, und Reduzieren des erwähnten Schwellenwerts (T) nur dann, wenn der erwähnte Schwellenwert (T) größer ist als der erwähnte vorbestimmte minimale Schwellenwert.

17. In der Hand zu haltende Nachrichtenvorrichtung (2) mit einem Sender und einer Antenne (1, 22) einschließlich einer Schaltung zur Steuerung der Aussetzungspegel der aus der Antenne (1, 22) austretenden HF-Sendungen (4) gegenüber einem Benutzer (3) der Nachrichtenvorrichtung (2), wobei folgendes vorgesehen ist;

ein HF-Aussetzungssteuerprozessor (20) mit zwei Eingängen, wobei ein erster Eingang zum Empfang eines Leistungsanforderungssignals dient und mit zwei Ausgängen, wobei ein erster Ausgang einen Aussetzungsschwellenwert liefert und ein zweiter Ausgang ein modifiziertes Leistungsanforderungssignal liefert;
ein Verstärker (21) mit zwei Eingängen, wobei ein erster Eingang zum Empfang eines Informationssignals dient und ein zweiter Eingang zum Empfang des erwähnten modifizierten Leistungsanforderungssignals und mit einem Ausgang zur Lieferung eines verstärkten Informationssignals an die Antenne (1, 22);
ein Verluste aufweisender (leaky)-Integrator (23) mit einem mit dem erwähnten modifizierten Leistungsanforderungssignal gekoppelten Eingang und mit einem Ausgang zur Bestimmung der durch die Antenne (1, 22) mit einer vorbestimmten Zeitspanne oder Zeitllänge übertragenen Energiemenge; und

ein Komparator (24) mit zwei Eingängen und einem Ausgang, wobei ein erster Eingang mit dem Ausgang des erwähnten Leaky-Integrators (23) gekoppelt ist, wobei ein zweiter Eingang mit dem erwähnten ersten Ausgang des Belichtungssteuerprozessors (20) verbunden ist und wobei der erwähnte Ausgang mit einem zweiten Eingang des erwähnten Aussetzungssteuerprozessors (20) gekoppelt ist.

18. In der Hand zu haltende Nachrichtenvorrichtung (2) mit einem Sender und einer Antenne (1, 22) einschließlich einer Schaltung zur Steuerung der Aussetzungspegel (Niveaus) eines Benutzers (3) der Nachrichtenvorrichtung (2) gegenüber HF-Sendungen (4), die aus der Antenne (1, 22) austreten, wobei folgendes vorgesehen ist;

ein HF-Aussetzungssteuerungsprozessor (20) mit zwei Eingängen, wobei ein erster Eingang zum Empfang eines Leistungsanforderungssignals dient und wobei zwei Ausgänge vorgesehen sind, von denen ein erster Ausgang zum Vorsehen eines Aussetzungsschwellenwertes dient und ein zweiter Ausgang zum Vorsehen eines modifizierten Leistungsanforderungssignals;
ein Verstärker (21) mit zwei Eingängen, und zwar mit einem ersten Eingang zum Empfang eines Informationssignals und mit einem zweiten Eingang zum Empfang des erwähnten modifizierten Leistungsanforderungssignals, und wobei ferner ein Ausgang vorgesehen ist, um ein verstärktes Informationssignal an die Antenne (1, 22) zu liefern;
ein Gleitfensterakkumulator (23) mit einem mit dem modifizierten Leistungsanforderungssignal gekoppelten Eingang und mit einem Ausgang zur Bestimmung der durch die Antenne (1, 22) in einer vorbestimmten Zeitlänge oder Zeitspanne übertragenen Energiemenge; und
ein Komparator (24) mit zwei Eingängen und einem Ausgang, wobei ein erster Eingang mit dem Ausgang des erwähnten Gleitfernsterakkumulators (23) gekoppelt ist und ein zweiter Eingang mit dem erwähnten ersten Ausgang des erwähnten Belichtungssteuerungsprozessor (20) gekoppelt ist und wobei schließlich der erwähnte Ausgang mit einem zweiten Eingang des Belichtungssteuerprozessors (20) gekoppelt ist.

19. Nachrichtenvorrichtung (2) nach Anspruch 17 oder 18, wobei der Aussetzungssteuerprozessor (20) ferner einen dritten Ausgang zur Lieferung eines Steuerbenachrichtigungs oder Notifikationssignals aufweist.

## Revendications

1. Système comprenant un dispositif de communication (2) comportant un émetteur et une antenne (1, 22) et un appareil pour limiter la puissance d'émission de l'émetteur, cet appareil comprenant :

un moyen de comparaison (24) pour comparer une valeur d'énergie d'émission ($E_t$) à une valeur de seuil (T) et produire un signal de résultat de comparaison ;
un moyen de réponse (20) pour recevoir le signal de résultat de comparaison et, quand le signal de résultat de comparaison indique que la valeur d'énergie d'émission (Et) dépasse le seuil (T), limiter la puissance d'émission (P(t) ou P(i)) de l'émetteur ;

caractérisé en ce que :

l'appareil est destiné à limiter le niveau d'exposition d'un utilisateur (3) aux émissions RF (4) en provenance du dispositif de communication (2) ; et
l'appareil comprend en outre un moyen (23) pour déterminer la quantité d'énergie émise par l'antenne (1, 22) en une durée prédéterminée ($\Delta t$) pour produire une valeur d'énergie accumulée (Et) qui constitue la valeur d'énergie d'émission.

2. Système selon la revendication 1, dans lequel le moyen de détermination (23) comprend un accumulateur à fenêtre glissante.

3. Système selon la revendication 1, dans lequel le moyen de détermination (23) comprend un intégrateur à fuite.

4. Système selon la revendication 1, 2 ou 3, dans lequel le moyen de réponse (20) est en outre destiné à informer l'utilisateur d'un état d'exposition à un rayonnement d'émission élevé quand le signal de résultat de comparaison indique que la valeur d'énergie accumulée ($E_t$) dépasse le seuil (T).

5. Système selon l'une quelconque des revendications précédentes, dans lequel le moyen de réponse (20) est en outre destiné, quand le signal de résultat de comparaison indique que la valeur d'énergie accumulée ($E_t$) dépasse la valeur de seuil (T), à comparer la valeur de seuil (T) à une valeur de seuil maximum prédéterminée, et si la valeur de seuil (T) est inférieure à la valeur de seuil maximum, à augmenter la valeur de seuil.

6. Système selon la revendication 5, dans lequel le moyen de réponse (20) est en outre destiné, quand le signal de résultat de comparaison indique que la valeur d'énergie accumulée ($E_t$) est inférieure à la valeur de seuil (T), à réduire la valeur de seuil (T).

7. Système selon la revendication 5, dans lequel le moyen de réponse (20) est en outre destiné, quand le signal de comparaison indique que la valeur d'énergie accumulée (Et) est inférieure à la valeur de seuil (T), à comparer la valeur de seuil (T) à une valeur de seuil minimum prédéterminée et à réduire la valeur de seuil (T) seulement quand la valeur de seuil (T) est supérieure à la valeur de seuil minimum.

8. Système selon la revendication 6, dans lequel le moyen de réponse (20) est en outre destiné à réduire la valeur de seuil (T) seulement quand la valeur de seuil (T) est supérieure à une valeur de seuil minimum.

9. Procédé d'utilisation d'un dispositif de communication (2) muni d'un émetteur et d'une antenne (1, 22) pour limiter la puissance d'émission de l'émetteur, comprenant les étapes suivantes :

comparer une valeur d'énergie d'émission ($E_t$) à une valeur de seuil (T) ;
produire un signal de résultat de comparaison ; et
limiter la puissance d'émission (P(t) ou P(i)) de l'émetteur si le signal de résultat de comparaison indique que la valeur d'énergie d'émission ($E_t$) dépasse la valeur de seuil (T) ;

caractérisé en ce que :

le procédé est destiné à limiter le niveau d'exposition d'un utilisateur (3) aux émissions RF (4) du dispositif de communication (2) ; et
le procédé inclut en outre l'étape consistant à déterminer la quantité d'énergie émise par l'antenne (1, 22) en une durée prédéterminée ($\Delta t$) pour produire une valeur d'énergie accumulée ($E_t$) qui constitue la valeur d'énergie d'émission.

10. Procédé selon la revendication 9, dans lequel l'étape de détermination de la quantité d'énergie émise par l'antenne (1, 22) comprend l'étape consistant à additionner la puissance d'émission (P(i)) sur un nombre prédéterminé de symboles émis (m).

11. Procédé selon la revendication 9, dans lequel l'étape de détermination de la quantité d'énergie émise par l'antenne (1, 22) comprend l'étape consistant à intégrer la puissance d'émission (P(t)) sur un intervalle de temps prédéterminé ($\Delta t$).

12. Procédé selon la revendication 9, 10 ou 11, comprenant l'étape consistant à informer l'utilisateur quand le résultat de la comparaison indique que la valeur d'énergie accumulée ($E_t$) dépasse la valeur de seuil (T).

13. Procédé selon la revendication 9, comprenant l'étape consistant à augmenter le seuil en réponse au signal de résultat de comparaison si le résultat de comparaison indique que la valeur d'énergie accumulée ($E_t$) dépasse la valeur de seuil (T).

14. Procédé selon la revendication 13, comprenant en outre l'étape consistant à réduire le seuil en réponse au signal de résultat de comparaison si le résultat de comparaison indique que la valeur d'énergie accumulée ($E_t$) est inférieure à la valeur de seuil (T).

15. Procédé selon la revendication 13, comprenant en outre les étapes consistant à comparer la valeur de seuil (T) à une valeur de seuil maximum prédéterminée et à augmenter la valeur de seuil (T) seulement quand la valeur de seuil (T) est inférieure à la valeur de seuil maximum prédéterminée.

16. Procédé selon la revendication 14, comprenant en outre les étapes consistant à comparer la valeur de seuil (T) à une valeur de seuil minimum prédéterminée et à réduire la valeur de seuil (T) seulement quand la valeur de seuil (T) est supérieure à la valeur de seuil minimum prédéterminée.

**17.** Dispositif de communication portable (2) comprenant un émetteur et une antenne (1, 22), incluant un circuit de commande du niveau d'exposition d'un utilisateur (3) du dispositif de communication (2) aux émissions RF (4) émanant de l'antenne (1, 22), comprenant :

un processeur de commande d'exposition RF (20) à deux entrées dont une première entrée est destinée à recevoir un signal de requête de puissance, et comportant deux sorties dont une première sortie pour fournir une valeur de seuil d'exposition et une seconde sortie pour fournir un signal de requête de puissance modifié ;
un amplificateur (21) à deux entrées, dont une première entrée pour recevoir un signal d'information et une seconde entrée pour recevoir le signal de requête de puissance modifié, et ayant une sortie pour fournir un signal d'information amplifié à l'antenne (1, 22) ;
un intégrateur à fuite (23) ayant une entrée couplée au signal de requête de puissance modifié et ayant une sortie pour déterminer la quantité d'énergie émise par l'antenne (1, 22) en une durée prédéterminée ; et
un comparateur (24) ayant deux entrées et une sortie, une première entrée couplée à la sortie de l'intégrateur à fuite (23) et une seconde entrée couplée à la première sortie du processeur de commande d'exposition (20), et dans lequel la sortie est couplée à une seconde entrée du processeur de commande d'exposition (20).

**18.** Dispositif de communication portable (2) comprenant un émetteur et une antenne (1, 22), incluant un circuit de commande du niveau d'exposition d'un utilisateur (3) du dispositif de communication (2) aux émissions RF (4) émanant de l'antenne (1, 22), comprenant :

un processeur de commande d'exposition RF (20) à deux entrées dont une première entrée est destinée à recevoir un signal de requête de puissance, et comportant deux sorties dont une première sortie pour fournir une valeur de seuil d'exposition et une seconde sortie pour fournir un signal de requête de puissance modifié ;
un amplificateur (21) à deux entrées, dont une première entrée pour recevoir un signal d'information et une seconde entrée pour recevoir le signal de requête de puissance modifié, et ayant une sortie pour fournir un signal d'information amplifié à l'antenne (1, 22) ;
un accumulateur à fenêtre glissante (23) ayant une entrée couplée au signal de requête de puissance modifié et ayant une sortie pour déterminer la quantité d'énergie émise par l'antenne (1, 22) en une durée prédéterminée ; et
un comparateur (24) ayant deux entrées et une sortie, une première entrée couplée à la sortie de l'accumulateur à fenêtre glissante (23) et une seconde entrée couplée à la première sortie du processeur de commande d'exposition (20), et dans lequel la sortie est couplée à une seconde entrée du processeur de commande d'exposition (20).

**19.** Dispositif de communication (2) selon la revendication 17 ou 18, dans lequel le processeur de commande d'exposition (20) comprend en outre une troisième sortie pour fournir un signal d'information de commande.

FIG. 1

FIG. 3

FIG. 2